# EUROPEAN PATENT APPLICATION

(11) **EP 0 661 386 A1**
(43) Date of publication of application: **05.07.1995**
(21) Application number: 94115055.9
(22) Date of filing: 23.09.1994
(51) Int. Cl.: C23C 16/34

(54) **A film deposition method**

(30) Priority: 24.09.1993 JP 238565/93
(71) Applicant: APPLIED MATERIALS, INC., Santa Clara California 95052-8039 (US)
(72) Inventor: Sato, Tatsuya, c/o Applied Materials, Shinizumi, Narita-shi, Chiba-ken (JP); Tabata, Atsushi, c/o Applied Materials, Shinizumi, Narita-shi, Chiba-ken (JP)
(74) Representative: Kahler, Kurt, Dipl.-Ing.

(57) **Abstract**

There is provided a film deposition method for forming SIN films and SION films with which the etching speed can be changed at low temperatures, and that possess low carbon contents and good step coating properties. SiH₄, NH₃, and N₂ were introduced from a pipe (61), HMDS was introduced from a pipe (62), and a reaction gas composed of HMDS, SiH₄, NH₃, and N₂ was introduced at 666.61 Pa (5 torr) into a reactor (1) through a pipe (60). In so doing, the temperature of the substrate was controlled at 300 - 450°C with a heater (7), and high frequency electrical power from high frequency oscillation sources (8) and (10) was applied at 0.02 W/cm². Within the reactor (1), a plasma was produced, and this plasma discharge energy excited the mixed gas, cleaving its chemical bonds and causing a reaction product made up of activated particles consisting of atomic and molecular radicals to be deposited upon a substrate (5), upon which it forms a SIN film.

## Description

### Detailed explanation of the invention

### Field of industrial utilization

The present invention concerns a method for forming silicon nitride films (referred to hereinafter as SIN [sic; SiN] films) and silicon nitrogen oxide films (referred to hereinafter as SION [sic; SiON] films). In particular, the present invention concerns a method for forming SIN films or SION films for use in objectives which include final protective films interlayer insulation films, and masks for use in etching in the area of semiconductor integrated circuits.

### Prior art

Due to their moisture resistance, SIN films and SION films are frequently used as good final protective films or insulation films employed for purposes which include insulation for wiring and protection for devices in the area of semiconductor devices such as semiconductor integrated circuits. Methods in which final protective films composed of such SIN films or SION films are formed by deposition due to plasma excitation chemical vapor phase deposition (referred to as PECVD hereinafter) in which a monosilane is used as the starting material have been known for many years.

Additionally, techniques in which SIN films and SION films are formed by the PECVD method using organosilane materials such as hexamethyldisilazane (referred to as HMDS hereinafter) as the starting material have come into use in recent years.

In forming items such as final protective films (passivation films) or interlayer insulation films for use between wires composed of materials such as Al or Al alloys, said insulation films or protective films, etc., must be formed at a low temperature of 450°C or less, below the melting point (about 600°C) of Al. Accordingly, the formation of items such as final protective films (passivation films) or interlayer insulation films for use between wiring by PECVD, in which films can be formed at comparatively low temperatures, will be seen with increasing frequency as time goes by.

### Problems the invention is intended to solve

However, it is known that with SIN films deposited by PECVD in which the aforementioned monosilane starting materials are used, the Si and N composition does not reach the chemical equivalent ratio (0.75), and large amounts of hydrogen and contained, with Si-H and N-H bonds also being present. Even in SION films deposited by PECVD in which a monosilane is used as the starting material, large amounts of hydrogen are contained, and Si-H and N-H bonds, etc., are present. For these reasons, when etching (wet etching) in which configuration design is carried out is performed with the use of an acid solution, the etching speed is 100 times or more higher than that with films formed by using a pyrolytic reaction under high temperature conditions in which the temperature of the semiconductor substrate is set at 600-700°C. Accordingly, the drawback occurs that SIN films and SION films formed by PECVD in which a monosilane is used as the starting material cannot be used as masking films or the like during etching in which high etching selectivity is demanded.

SIN films and SION films deposited by PECVD in which the aforementioned organosilanes are used as starting materials have high etching selectivity. However, they have the drawback of being inferior from the standpoints of characteristics such as their high carbon content and poor stepped coating configuration when compared to films deposited by PECVD in which monosilanes are used as the starting materials. They have the additional fault that, although PECVD in which organosilanes are used as the starting materials can be utilized to form films at low temperatures, organic resins are then formed, which makes the products unsuitable for use as SIN films and SION films employed as items such as final protective films for semiconductor devices.

The present invention has been conceived for the purpose of solving the aforementioned problems, and has the purpose of providing a thin-film-forming method for forming a SIN film or a SION film that allows the selection of the etching speed at low temperatures, possesses a low carbon content and good stepped coating properties, and can be used as a process sacrifice film.

### Means used to solve the aforementioned problems

The thin-film-forming method of the present invention is characterized in that it includes (a) a step in which high frequency electrical power is applied to a mixed gas composed of a monosilane compound, an organosilane compound, and a nitrogen compound to produce a plasma within a reactor containing a substrate, and (b) a step in which this plasma discharge energy excites the mixed gas, causing a reaction product to be deposited as a SIN film upon the aforementioned substrate. The present invention can also be characterized in that the aforementioned mixed gas also contains a nitrogen oxide, and deposits a SION film.

Here, the present invention can also be characterized in that the monosilane compound is at least one compound selected from SiH₄, Si₂H₆, Si₃H₈ and SiCl₂H₂, the organosilane compound is at least one compound selected from between (CH₃)₃SINHSi(CH₃)₃ and (CH₃)₃SIN(CH₃)₂ or the like, and the nitrogen compound is at least one compound selected from among NH₃ and N₂.

### Action

When the thin film formation method of the present invention is implemented, first, a gas composed of a monosilane compound, a gas composed of an organosilane compound, and a gas composed of nitrogen oxide are introduced into the reactor. High frequency electrical power is then applied to the mixed gas within the reactor to generate a plasma, and this plasma discharge energy excites the mixed gas and breaks its chemical bonds so that a reaction product made up of active particles consisting of atomic or molecular radicals is deposited upon the substrate.

Since both monosilane compounds and organosilane compounds can be the supply source for Si in the SIN film and the SION film, a film that is more advantageous as a final protective film or a mask during etching than the film obtained when only one from between a monosilane compound and an organosilane compound is used as the Si supply source can be formed by the low temperature process of PECVD.

In the present invention, the monosilane compound is a compound expressed by the structural formula SiₙH₂ₙ₊₂, and also includes compounds in which some of the H is substituted by Cl. n = 1-3 monosilane compounds are preferable in the present invention.

In the present invention, the organosilane compound is a silane compound containing an organic group. Silazane compounds are preferably used as the organosilane compound in the present invention.

In the present invention, the flow rate ratio between the monosilane compound and the organosilane compound (defined as: (organosilane compound concentration (molar concentration)/(organosilane compound concentration (molar concentration) + monosilane compound concentration (molar concentration))) should be 5 - 50%.

In the present invention, the nitrogen compound is a compound containing a nitrogen atom (including simple N₂), and refers to materials that do not contain an oxygen atom. N₂ or NH₃ is desirable as the nitrogen compound in the present invention. It is also possible for these nitrogen compounds to act as the carrier gas.

In the present invention, a carrier gas can be used as needed to introduce the aforementioned monosilane compounds, organic monosilane compounds, nitrogen compounds, and compounds of nitrogen oxide into the reactor. Inert gases such as Ar and He can be preferably used as this carrier gas.

In the present invention, conditions such as those shown below can be preferably used as reaction conditions in addition to the aforementioned reaction conditions.

| | |
|---|---|
| Pressure: | 13.33 - 1333.22 Pa (10⁻¹ - 10 torr) |
| High frequency frequency: | 200 kHz - 13.56 MHz |
| High frequency electrical power: | 200 - 1,000 W |
| Substrate temperature: | 300 - 400 °C |

### Brief explanation of the figures

- Fig. 1: is an explanatory diagram (cross-sectional view) of the formation of a SIN film pertaining to the application example of the present invention.
- Fig. 2: is a general structural view of the PECVD device used in the application example.
- Fig. 3: is a graph showing the dependency of the wet etching speed on the flow rate ratio between the organosilane compound and the monosilane compound.
- Fig. 4: is a graph showing the dependency of infrared absorption spectra distribution on the flow rate ratio between the HMDS and the monosilane compound.

### Application examples

Application examples of the present invention will be described below on the basis of the appended figures.

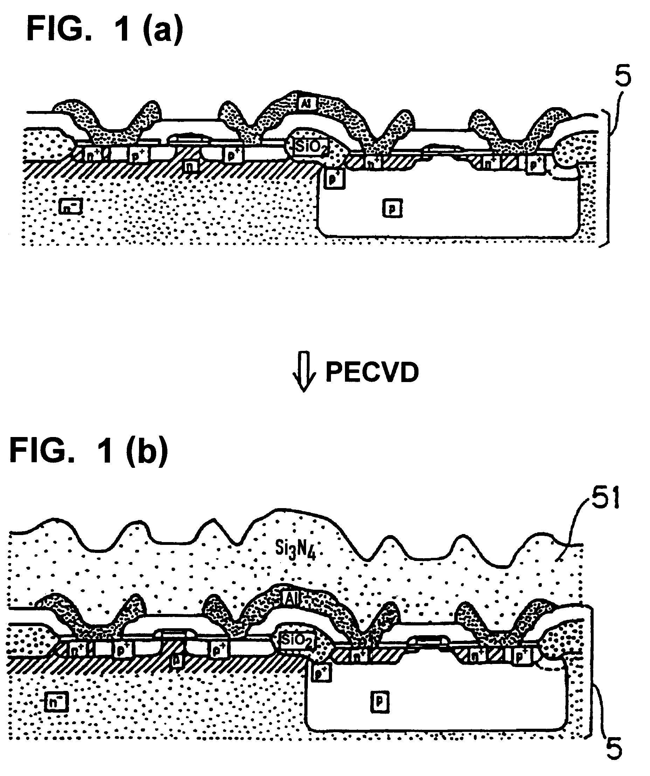

Figure 1 is an explanatory diagram of the formation of a SIN film upon a substrate by the film formation method of the present application examples. Figure 1(a) shows the structure of the substrate 5 prior to the formation of the SIN film, and Fig. 1(b) shows the formed SIN film 51 upon the substrate 5.

The formation of this SIN film 51 is carried out in the following manner.

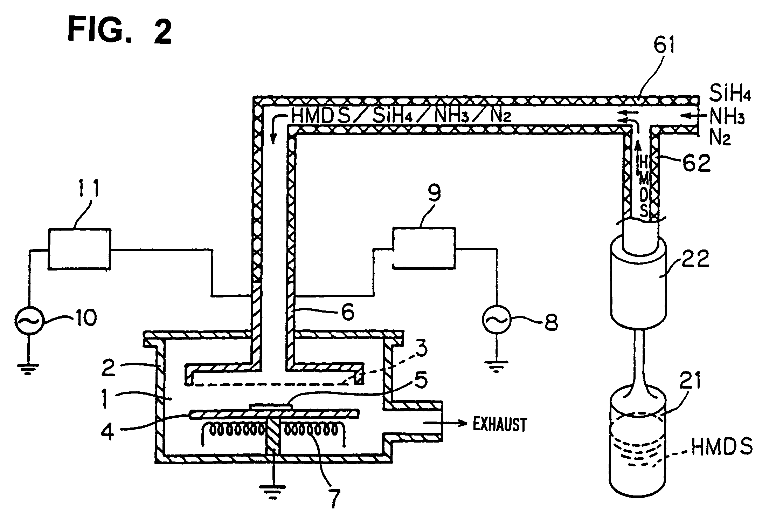

First, the substrate 5 is arranged within a PECVD device. Figure 2 is a general structural diagram of the PECVD device employed in the present application example. As shown in the figure, in this PECVD device, counter electrodes 3 and 4 are accommodated within an insulating reactor 2 intended to provide a reaction chamber 1 sealed in an airtight manner. Said PECVD device is arranged such that the one electrode 4 is maintained at ground potential and has a semiconductor substrate 5 for thin film formation mounted on its side that faces the other electrode 3, and high frequency electrical power output from high frequency oscillation sources 8 and 10 for plasma generation is applied through impedance matching circuits 9 and 11 to the other electrode 3. The reaction gas is introduced from the top side of the electrode 3 to the reaction chamber 1 through a pipe 6. This reaction gas consists of a mixed gas of a monosilane compound and an organosilane compound that has passed through a pipe 61, and hexamethyldisilazane (HMDS) from a liquid holding container 21 that has passed through a flow rate controller 22 and then through a pipe 62. The PECVD device is structured such that the unneeded part of the reaction gas is exhausted from an exhaust port of the reactor 2. A heater 7 for temperature control is provided on the electrode 4 side.

SiH₄, NH₃, and N₂ were introduced from the pipe 61, and HMDS was introduced from the pipe 62. In this manner, the reaction gas was introduced through the pipe 6 into the reaction chamber 1 under conditions of 666.61 Pa (5 torr), partial pressure ratio (HMDS, SiH₄, NH₃, N₂) of 3 : 1 : 6 : 3, and flow rate of 1,300 sccm. In so doing, the temperature of the substrate was controlled at 300 - 450°C with heater 7, and high frequency electrical power from the high frequency oscillation sources 8 and 10 was applied at 0.02 W/cm². Within the reaction chamber 1, the application of the high frequency electrical power generated a plasma, and this plasma discharge energy excited the mixed gas and cleaved its chemical bonds, causing a reaction product made up of active particles consisting of atomic and molecular radicals to be deposited upon the substrate 5, upon which it forms the SIN film 51.

As a result of investigating the characteristics of the SIN film formed in the aforementioned manner, it was found that its index of refraction was 2.00 or above (measured by epurisometry [transliteration]), and its film stress under compression was -2 x 10⁹ or above (measured by laser interferometry). These values were equivalent to those for SIN films obtained by pyrolysis. The etching speed with an acid buffering solution (HF : NH₄F = 6 : 1) called "6 : 1 BOE" was 0.5 nm/min (5 Å/min) or less. The stepped coating properties were equivalent to those for a SIN film obtained by PECVD in which monosilane was used as the starting material, and no pinholes were produced (measurement performed by immersion in aqua regia). The carbon content was 3% or less, a value on the order of 1/2.7 that when no monosilane compound was mixed (calculated by means of infrared absorption spectroscopy from the sums of the absorption spectrum intensities indicating C-H bonds).

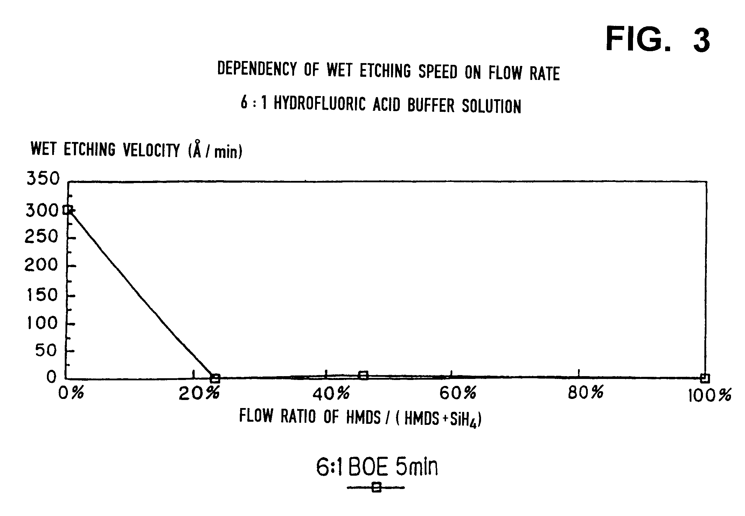

The inventors observed variations in the wet etching speed that depended on the flow rate ratio between the monosilane compound and the organosilane compound, and performed a measurement thereof. Figure 3 is a graph of the results obtained by measuring the wet etching speed of 6 : 1 BOE at different HMDS and SiH₄ flow rate ratios (HMDS (mol))/(HMDS (mol)) + SiH₄ (mol) with the overall flow rate of these materials kept at a fixed value, under the same formation conditions as were used with the aforementioned SIN film. As shown in the figure, the wet etching speed decreased as the flow rate ratio increased during the time that the flow rate ratio moved from 0% to approximately 20%, whereas when the flow rate ratio was approximately 20%, after the wet etching speed became 0.5 nm/min (5 Å/min) or less, no significant change took place in the wet etching speed even if the flow rate ratio was increased.

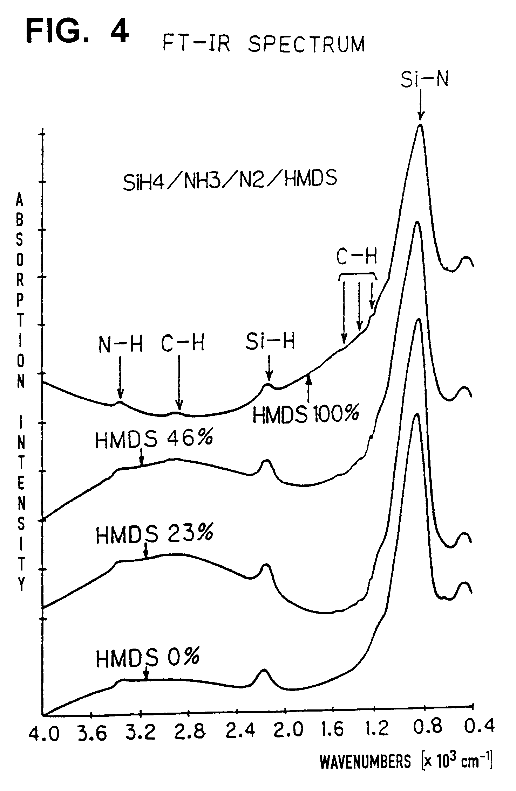

The inventors also used infrared absorption spectroscopy to measure the changes in the carbon content caused by the flow rate ratios. Figure 4 is a graph of the results obtained by measuring the wavenumber distribution of the absorption intensities at flow rate ratios of 0%, 23%, 46%, and 100%. As shown in the figure, it was observed that, with higher flow rate ratios, the spectrum indicating C-H bonds had more sharply defined peaks, and the carbon content increased. It was possible to determine the carbon content quantitatively from the values of these peaks.

The inventors also observed that the stepped coating properties deteriorated the more the flow rate ratio increased (measurement performed by scanning electron microscopy). Although said stepped coating properties fluctuated depending on conditions such as the SIN film formation temperature and the amount of electrical power, when compared to the stepped coating properties obtained when HMDS was not mixed in, it was confirmed that, under the aforementioned SIN film formation conditions, no significant difference would occur if the flow rate ratio was 10 - 50%.

The present invention is mutable, and not limited to the aforementioned application examples.

For example, although SiH₄ was used as the monosilane compound in the formation of the SIN film in the above application example, a film can be formed in the same manner using Si₂H₆, Si₃H₈, SiCl₂H₂, or a mixture of these monosilane compounds. Also, although (CH₃)₃SiNHSi(CH₃)₃ was used as the organosilane compound, a film can be formed in the same manner using (CH₃)₂SiN(CH₃)₂ or a mixture of these organosilane compounds. Moreover, although NH₃ was used as the nitrogen compound, a film can be formed in the same manner using N₂ or a mixture of these nitrogen compounds.

While the application example cited above pertained to the formation of a SIN film, if nitrogen oxide such as NO or NO₂ is added to the mixed gas used in the aforementioned application example, selection of the etching speed will be possible, and the formation of a SION film possessing a low carbon content and good stepped coating properties will be enabled. In forming this SION film, the selection of the monosilane compound, the organosilane compound, and the selection of nitrogen oxide can be changed in the same way as when forming a SIN film.

The reaction devices that can be used in the film formation of the present invention are not especially limited to PECVD devices possessing a reactor that contains a substrate, an introduction system capable of introducing into this reactor mixed gases containing monosilane compounds, organosilane compounds and nitrogen compounds, or mixed gases obtained by the addition of nitrogen oxides to these mixed gases, and electrodes that apply high frequency electrical impulses to these mixed gases. For example, although a device with a parallel flat plate electrode structure was used in the above application example, film formation can be performed in the same manner using a PECVD device provided with a plasma electrode structure of the coil discharge or other type.

As has been explained above in detail, when the film formation method of the present invention is implemented, because a SIN film or a SION film is formed using mixed gases containing monosilane compounds, organosilane compounds and nitrogen compounds, or mixed gases to which nitrogen oxides have been added, it is possible to obtain an improvement in (1) the high etching speed in SIN films or SION films formed by plasma CVD using mixed gases composed of monosilane compounds and nitrogen compounds, or mixed gases obtained by the addition of nitrogen oxides to these materials, and (2) the poor step coating properties and production of large amounts of carbon resin in SIN films or SION films formed by plasma CVD using mixed gases composed of organosilane compounds and nitrogen compounds, or mixed gases obtained by the addition of nitrogen oxides to these materials, and it is thus possible to form a SIN film or a SION film that enables selection of the etching speed at low temperatures, has a low carbon content and has good step coating properties.

Accordingly, when the SIN film or the SION film formed by the film-forming method of the present invention is used, its characteristics of good step coating properties, low carbon content, and low etching speed, etc., make it possible to increase the protective effect for semiconductor devices. Additionally, when these films are used as process sacrifice films in items such as masks during the thin film configuration processing of semiconductor elements or the like, their good step coating properties and high etching selectivity enable fine processing.

## Claims

1. A film deposition method,
**characterized** by
the steps of:
applying high frequency electrical power to a mixed gas composed of a monosilane compound, an organosilane compound and a nitrogen compound to produce a plasma within a reactor containing a substrate and
exciting the mixed gas by this plasma discharge energy, causing a reaction product to be deposited upon the aforementioned substrate.

2. The film deposition method according to claim 1,
**characterized** in
that the aforementioned mixed gas also contains nitrogen oxides.

3. The film deposition method according to claim 1 or 2,
**characterized** in
that the aforementioned monosilane compound is at least one compound selected from among SiH₄, Si₂H₆, Si₃H₈, and SiCl₂H₂.

4. The film deposition method according to any of claims 1 to 3,
**characterized** in
that the aforementioned organosilane compound is at least one compound selected from among (CH₃)₃SINHSi(CH₃)₃ and (CH₃)₃SIN(CH₃)₂.

5. The film deposition method according to any of claims 1 to 4,
**characterized** in
that the aforementioned nitrogen compound is at least one compound selected from between NH₃ and N₂.

6. The film deposition method according to any of claims 2 to 5,
**characterized** in
that the aforementioned nitrogen oxide is at least one compound selected from between NO and NO₂.
